Europäisches Patentamt

European Patent Office

Office européen des brevets

(19)

(11) Publication number: **0 170 703**
A1

# EUROPEAN PATENT APPLICATION

published in accordance with Art. 158(3) EPC

(21) Application number: 85900497.0

(22) Date of filing: 27.12.84

Data of the international application taken as a basis:

(86) International application number:
PCT/JP 84/00626

(87) International publication number:
WO 85/02946 (04.07.85 85/15)

(51) Int. Cl.⁴: **H 01 R  11/01,** H 01 R  43/00,
H 05 K  1/11, H 05 K  3/32,
G 09 F  9/00, H 01 B  5/16

(30) Priority: 28.12.83 JP 248396/83

(71) Applicant: Nissha Printing Co., Ltd., 3, Mibu Hanai-cho,
Nakakyo-ku Kyoto-shi Kyoto-fu 604 (JP)
Applicant: Matsushita Electric Industrial Co., Ltd., 1006,
Oaza Kadoma, Kadoma-shi Osaka-fu, 571 (JP)

(43) Date of publication of application: 12.02.86
Bulletin 86/7

(72) Inventor: MATSUMURA, Kozo, 22-81, Oyamazaki-cho
Kagamida, Otokuni-gun Kyoto-fu 618 (JP)
Inventor: OGAWA, Yukio Room 201 City Heim
Matsukura, 25-7, Shintakane 3-chome, Funabashi-shi
Chiba-ken 273 (JP)

(84) Designated Contracting States: DE FR GB

(74) Representative: Senior, Alan Murray et al, J.A. KEMP &
CO 14 South Square Gray's Inn, London WC1R 5EU (GB)

(54) FILM-SHAPED CONNECTOR AND METHOD OF MANUFACTURING THE SAME.

(57) A conductive circuit pattern portion is formed on an insulating substrate film, the pattern portion being constituted by a laminate of a thin metal film pattern layer with excellent electrical properties and an easily formable printed pattern layer, and a hot-melt adhesive layer with anisotropic electrical conductivity is further formed on the circuit pattern portion, whereby it is possible to easily a flexible conductive film connector which is accurately formed with a minute conductive circuit pattern having excellent electrical characteristics. The conductive film connector has excellent electrical characteristics and makes it possible to obtain complete adhesion. Further, there is no danger that the conductive film connector will fail as a result of long use; hence, it provides a highly reliable connection.

SPECIFICATION

TITLE OF THE INVENTION

FILM CONNECTOR AND METHOD FOR MAKING SAME

TECHNICAL FIELD

This invention relates to a film connector which is used for connection between printed circuit boards or between a printed circuit board and an electrode of electrical and electronic apparatus and also to a method for making same.

BACKGROUND ART

Several types of flexible connectors, which are used for connection between printed circuit boards or between a printed circuit board and an electrode of electrical and electronic apparatus, are known including:

(1) a sheet connector in which conductive rubber thin sheets and insulative rubber thin sheets are alternately superposed and bonded together and the resulting multilayer laminate is cut thin in the direction intersecting with the laminate surface;

(2) a film connector which is obtained by cutting thin a molded product of a multitude of conductive fine wires arranged parallel to each other and embedded in a polymeric insulative material; and

(3) a flexible film connector which is obtained by mixing conductive metal particles with an insulating elastic

- 1 -

material such as silicone rubber and shaping the mixture in the form of a sheet.

However, all the connectors have the following drawbacks. With the connectors (1) and (2), they are expensive because of the complicated manufacturing process and the high precision required and are not reliable because of the physical contact bonding of the connecting portion to an opposite electrode. With the connector (3), uniform conductivity cannot be reliably expected due to the irregularity in size of the conductive particles, and the connection to an opposite electrode is based on the physical contact bonding and is not thus reliable.

In order to solve the above problems, there has been proposed a film connector which is obtained by forming a desired vertically-striped, elongated connector circuit pattern on a flexible insulative base film by a screening printing technique using an insulative, thermally contact bonding suspension and a conductive suspension, and cutting the base film to a desired size (Japanese Patent Publication No. 58-12586).

However, this connector has the following various problems, which are now discussed with reference to the drawings.

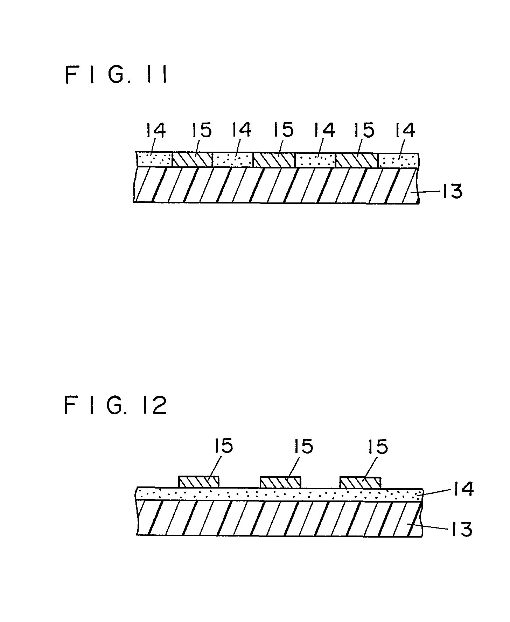

Figs. 11 and 12 are sectional views of film connectors described in Japanese Patent Publication No. 58-12586, respectively. In Fig.s 11 and 12, by 13 is designated a flexible insulative base film, by 14 is a thermally contact bonding layer formed from an insulative thermally contact bonding suspension by the use of screen printing, and by 15 is a conductive vertically-striped elongated layer. In such a connector, however, the connection between electrodes relies only on the applied portions of the insulative thermally contact bonding suspension and is not reliable because of the poor adhesion. Moreover, since the conductive circuit pattern is formed from a conductive paste, it is difficult to form the pattern of low resistance without involving a scattering of resistance. The connector shown in Fig. 11 is disadvantageous in that precise registration of the insulative thermally contact bonding suspension and the conductive suspension is essential on printing, so that it is difficult to form a fine conductive circuit pattern.

## SUMMARY OF THE INVENTION

According to the present invention, there is provided a a flexible film connector which comprises an insulative base film, a conductive circuit pattern unit formed on the base film and consisting of a laminate of a conductive metal thin pattern layer and a conductive printed pattern layer having the function as an etching resist, and a hot-melt adhesive layer formed on the pattern-bearing base film and

- 3 -

having anisotropic conductivity whereby a fine conductive circuit pattern having good electrical characteristics can be precisely formed.   The present invention also provides a method for readily making the film connector.

### BRIEF DESCRIPTION OF THE DRAWINGS

Figs. 1 to 3 are sectional views of film connectors according to the invention, respectively;

Figs. 4 to 7 are sectional views showing the steps of making a film connector according to the invention;

Figs. 8 to 10 are sectional views illustrating the application of a film connector according to the invention; and Figs. 11 and 12 are sectional views of known connectors, respectively.

### BEST MODE FOR CARRYING OUT THE INVENTION

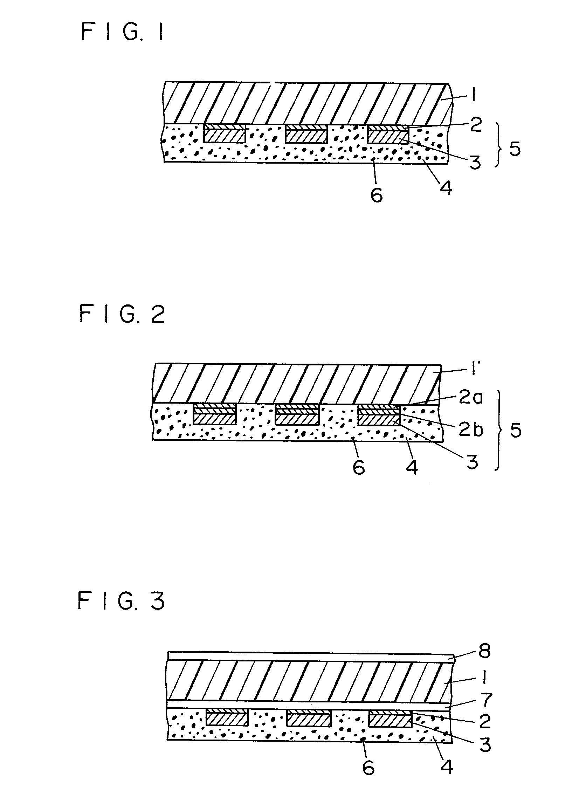

Fig. 1 is a sectional view showing a film connector according to one embodiment of the invention.

In the figure, indicated by 1 is a insulative base film, by 2 is a conductive metal thin pattern layer, by 3 is a conductive printed pattern layer, by 4 is an anisotropically conductive hot-melt adhesive layer and by 5 is a conductive circuit pattern unit consisting of a laminate of the metal thin pattern layer 2 and the printed pattern layer 3.   Reference numeral 6 indicates conductive powder dispersed in the adhesive layer 4.

Fig. 2 is a sectional view showing a film connector according to another embodiment of the invention.

In the figure, indicated by 1 is an insulative base film, by 2a and 2b are at least two conductive metal thin pattern layers of different metal materials, respectively, by 3 is a conductive printed layer, by 4 is a hot-melt adhesive layer in which conductive powder 6 is dispersed and which has anisotropic conductivity, and by 5 is a conductive circuit pattern unit consisting of a laminate of the metal thin pattern layers 2a, 2b and the printed pattern 3.

Fig. 3 is a sectional view showing a film connector according to a further embodiment of the invention.

In the figure, indicated by 1 is an insulative base film, by 2 is a conductive metal thin pattern layer, by 3 is a conductive printed pattern layer, by 4 is an anisotropically conductive hot-melt adhesive layer in which conductive powder 6 is dispersed, by 5 is a conductive circuit pattern unit consisting of a laminate of the metal thin pattern layer 2 and the printed pattern layer 3, by 7 is a primer layer, and by 8 is a back coat layer.

While a method for making the film connectors is described, the individual layers are illustrated in more detail.

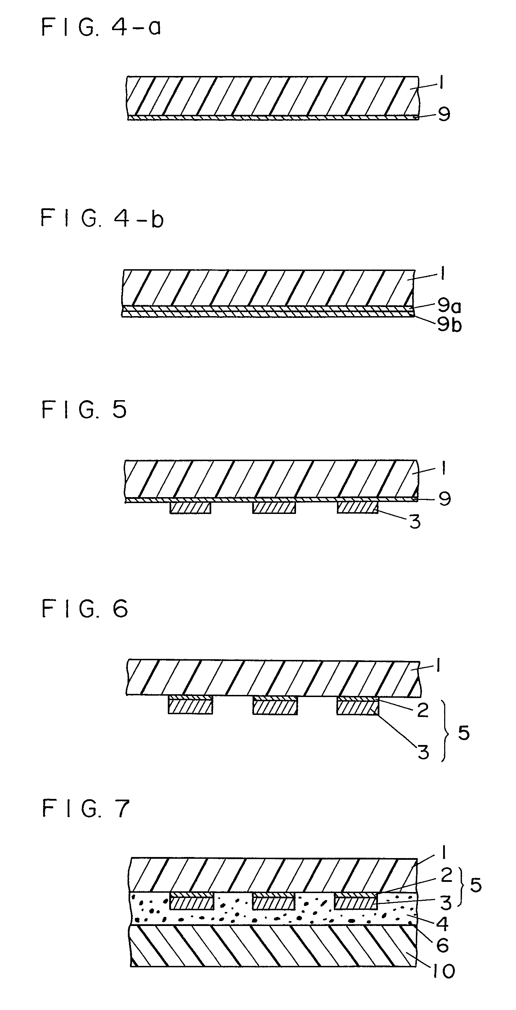

Figs. 4 to 7 are sectional views showing the steps of making the film connectors shown in Figs. 1 and 2, respectively.

First, a metal thin layer 9 is formed on the insulative base film 1 by the use of an electrically conductive metal material (see Fig. 4-a).

The insulative substrate film 1 used in the practice of the invention is a flexible plastic film having good dimensional stability and good electrical insulating properties. Such films may be simple or composite films made, for example, of polyester films, polyimide films, polycarbonate films, polysulfone films, polyether-sulfone films and polyphenylene oxide films. The film thickness is preferably in the range of 12 μm - 100 μm. If the thickness is smaller than 12 μm, the dimensional stability becomes poor and such a film is difficult to handle. On the other hand, when the thickness exceeds 100 μm, the flexibility problem arises in practical applications.

The insulative base film 1 should preferably be a film which has been subjected to corona discharge treatment, plasma treatment or chemical treatment or exposed to gas flame or coated with the primer layer 7 in order to increase the adhesion strength with respect to the conductive metal thin layer 9 which will be discussed below. In addition, in order to prevent curling, the back coat layer 8 may be formed on the base film (see Fig. 3).

The conductive metal thin layer 9 is formed using a metal material including an elemental metal such as gold, silver, copper, aluminium, nickel or the like, alloys of these metals, or a metal oxide such as tin oxide, indium oxide or the like. The thickness of the layer 9 is generally in the range of 100 angstrom - 10,000 angstrom, preferably 500 angstrom - 5,000 angstrom. The thin layer 9 may be formed by various methods including vacuum evaporation, sputtering, CVD and chemical plating.

It should be noted that the metal thin layer 9 may consist of two or more layers of different metal materials suitably selected from the above-defined metal materials (see Fig. 4-b). By this, not only good electric characteristics, but also high stability in quality is ensured. For instance, it is preferred to use a combination of a metal material of low resistance such as gold, silver, copper or aluminium and a metal material having good stabilities to humidity, temperature and air, e.g. nickel, tin, indium oxide or tin oxide. In Fig. 4-b, reference numerals 9a and 9b indicate two thin layers of metal materials as described above.

Next, an electrically conductive printing ink serving as an etching resist after drying is applied, in a desired pattern, onto the insulative base film 1 on which the metal thin layer 9 has been formed, thereby forming the printed pattern layer 3 (see Fig. 5).

The conductive printing ink having the function as an etching resist may be a conductive carbon paste, silver paste, copper paste, nickel paste or the like. The binder for the ink may be either an acid-resistant binder or an alkali-resistant binder which is properly selected depending on the etching process described hereinafter.

The conductive printed pattern ink 3 may be formed by various printing techniques such as screen printing, letterpress printing, litho printing, flexo printing and the like. In the film connector according to the invention, the conductive circuit pattern unit 5 is formed by suitable printing means, so that the pattern can be in any desired form.

Subsequently, the conductive thin layer 9 is etched through the resist of the printed pattern layer 3 (see Fig. 6). The etching may be effected by immersing the insulative base film 1, on which the conductive thin layer 9 and the printed pattern layer 3 have been formed, in an etchant solution capable of etching the thin layer 9 alone. The conductive thin layer 9 is thus removed in portions not covered with the printed pattern layer 3.

As a consequence, the conductive metal thin pattern layer 2 which is exactly coincident with the printed pattern 3, is formed thereby producing the conductive circuit pattern unit 5. This unit 5 consists of a laminate of the printed pattern layer 3 and the metal thin pattern layer 2.

Needless to say, the etching may be effected by a dry process as well as by the wet process.

Then, the anisotropically conductive adhesive layer 4 is formed on the surface on which the conductive circuit pattern unit 5 has been formed (see Fig. 1). The hot-melt adhesive layer 4 may be formed on the entire surface, or at least partially on portions which are to be connected to an opposite electrode.

The hot-melt adhesive layer 4 is comprised of a mixture an ordinary hot-melt adhesive dispersing the conductive powder 6. Examples of the hot-melt adhesive include vinyl acetate resins, vinyl resins, acrylic resins, waxes, polyolefins, polyamides, synthetic resins and the like, which may be used singly or in combination. Examples of the conductive powder include powders of carbon, gold, silver, copper, nickel, tin oxide, indium oxide and the like. The amount of the conductive powder dispersed in the adhesive is suitably determined in such a way that the hot-melt adhesive 4 shows the anisotropic conductivity. For instance, with carbon black, the amount is generally in the range of 0.1 - 20 parts by weight, preferably 0.5 - 10 parts by weight, per 100 parts by weight of the adhesive. Amounts less than 0.1 part by weight per 100 parts by weight of the adhesive do rarely produce the function as a connector because the number of the conductive particles as existing between the electrode and an opposite electrode becomes too small. On the other hand, when the amounts exceed 20 parts by weight, the hot-melt adhesive layer 4 is rendered conductive, so that the function as connector cannot be attained as well. The thickness of the hot-melt adhesive layer 4 is preferably in the range of 1 - 100 µm. Thicknesses less than 1 µm lead to a lowering of adhesion strength, whereas when the thickness exceeds 100 µm, there is the possibility of conduction failure.

The adhesive layer 4 may be formed, by coating or printing, directly on the surface on which the conductive circuit pattern unit 5 has been formed. Alternatively, the adhesive layer 4 may be formed on a separately provided carrier film 10 by coating or printing. The adhesive layer 4 on the carrier film 10 is then laminated on the surface bearing the conductive circuit pattern unit 5 (see Fig. 7).

Reference is now made to the use of the film connector.

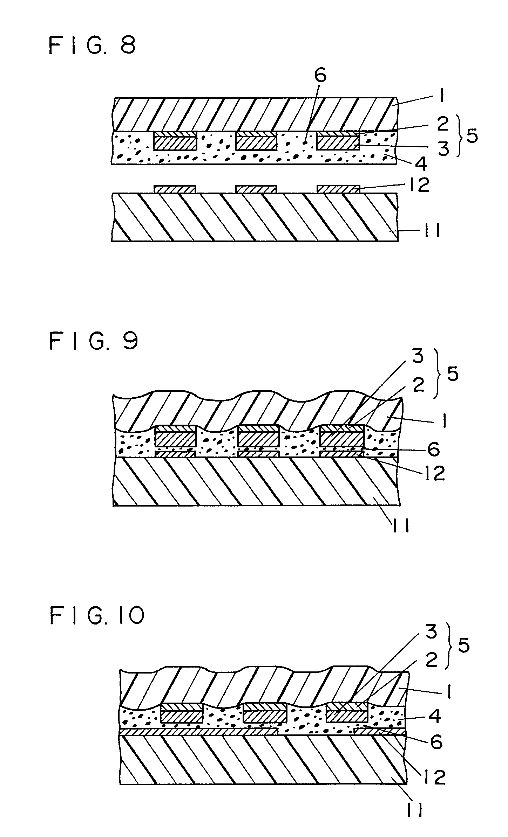

In application of the film connector shown in Fig. 1, the conductive circuit pattern unit 5 is superposed, for example, on a corresponding transparent electrode pattern 12 formed on a glass substrate 11, and hot-pressed (see Figs. 8, 9 and 10). As a result, the conductive powder 6 in the hot-melt adhesive layer 4 is left between the conductive circuit pattern unit 5 and the transparent electrode pattern 12, so that electric conduction is ensured while completing the contact bonding by the melt and bonding action of the hot-melt adhesive.  Thus, the conductive circuit pattern unit 5 and the transparent electrode pattern 12 are interconnected.

The film connectors shown in Figs. 2 and 3 may also be used similar to the connector of Fig. 1.

Aside from the application to the transparent electrode, the film connectors of the present invention may also be applied for connection between electrodes of printed circuit boards and for connection to electrodes of various electrical and electronic apparatus.

According to the method of the invention, since the conductive circuit pattern can be formed by the step of forming the metallic thin film and the printing step, the film connector having a desired conductive circuit pattern can be very readily made.

The film connector obtained by the present invention makes use of a low resistance metallic thin pattern layer as one of the layers constituting the conductive circuit pattern unit and has thus good electrical characteristics. Moreover, since the conductive circuit pattern unit is connected to an opposite electrode by the bonding action of a hot-melt adhesive, complete bonding is obtained without the danger of conduction failure in a long-term service, ensuring high reliability with regard to the connection.

Accordingly, the film connectors of the invention can be effectively utilized for connection between printed circuit boards of electronic computers and peripheral equipments, communication systems, broadcasting systems, control systems, instrumentation systems, telegraph and telegram systems and various display systems and also for connection between the printed circuit board of the above systems and an electrode of other electrical and electronic apparatus.

Example 1

Aluminium films and a copper film whose thicknesses are indicated at (1) below, were each deposited, as a conductive metal thin film, on a 25 $\mu$m thick corona-discharged polyester film.

    (1) Deposited aluminium film:  600 angstrom 800 angstrom 1000 angstrom

    Deposited copper film:    1000 angstrom Thereafter, a printing ink having the following formulation (2) was applied onto the metal thin layer of each of the four conductive thin films by means of a screen printing machine, thereby forming a 50 mm square vertically-striped conductive connector circuit pattern having a line width of 0.3 mm, a pitch of 0.6 mm and a dry thickness of 10 um, dried and cured at 130$^{o}$C for 0.5 hours.

(2) Printing ink Binder:  phenolic resin Solvent: polyhydric alcohol derivative Main ingredients: carbon and graphite Viscosity: 168,000 - 176,000 cps (revolutions of the rotor of a rotational viscometer: 10 r.p.m.)

Subsequently, the metal thin film was subjected to the etching treatment through the printed pattern layer serving as the etching resist using an aqueous weakly alkaline solution for the deposited aluminium films and a mixed solution of diluted sulfuric acid and ferric chloride for the deposited copper film, thereby forming, on the polyester film, a conductive circuit pattern unit consisting of the printed pattern layer and the thin pattern layer.

After washing with water and drying, a hot-melt adhesive of the following formulation (3) was applied by screen printing so that the conductive connector circuit pattern was entirely covered in a thickness of 5 - 6 µm.

(3)  Ethylene-vinyl acetate copolymer SnO powder     10 wt%

The resultant film connectors were bonded under the following contact bonding conditions (4).  The results of the electrical resistance are shown in Table 1.  In Table 1, there are also shown the results of the electrical resistance of a film connector of the type whose conductive circuit pattern is made of a conductive paste alone.

(4) Contact bonding conditions (in air) Temperature   150°C Time          10 seconds Pressure      40 kg/cm$^2$

Table 1

| | Electric Resistance on conduction, 50 mm in length x 0.3 mm in width |
|---|---|
| known connector | 11 kΩ ± 1 kΩ |
| deposited aluminium film | 600 angstrom   0.80 kΩ ± 0.10 kΩ<br>800 angstrom   0.80 kΩ ± 0.05 kΩ<br>1000 angstrom   0.60 kΩ ± 0.05 kΩ |
| deposited copper film | 1000 angstrom   0.02 kΩ ± 0.005 kΩ |

As will be seen from the results of Table 1, the film connectors of the present invention are much far lower in electric resistance on conduction than the known connector whose conductive circuit pattern consists of the conductive

- 14 -

paste alone.

Example 2

A metal thin layer consisting of copper and nickel layers was formed on a 38 μm thick corona-discharged polyester film by vacuum deposition of a 2000 angstrom thick copper film and a 400 angstrom thick nickel film superposed on the copper film.

Thereafter, a printing ink having the following formulation (5) was applied onto the metallic thin layer by screen printing to form a 332 mm long x 167 mm wide, vertically-striped conductive circuit pattern having a line width of 0.325 mm, a pitch of 0.65 mm and a dry thickness of 10 um, followed by drying and curing in air at 130°C for 0.5 hours to form a conductive printed pattern layer on the metallic thin layer.

(5) Printing ink Binder: phenolic resin Solvent: polyhydric alcohol derivative Main ingredients: carbon and graphite

Viscosity: 40,000 - 45,000 (revolutions of the rotor of a rotational viscometer: 20 r.p.m.)

Subsequently, the metallic thin film was subjected to the etching treatment through the printed pattern layer serving as the etching resist using a ferric chloride solution to form a metallic thin pattern layer corresponding to the printed pattern. Thus, a conductive circuit pattern unit consisting of the printed pattern layer and the thin pattern layer was formed on the polyester film.

After washing with water and drying, a hot-melt adhesive layer of the following formulation (6), which had been formed on a carrier film, was applied by lamination so that the conductive connector circuit pattern was entirely covered.

(6)  Linear saturated polyester resin   72 parts by weight
     Tackifier                          20 parts by weight
     Additive                            2 parts by weight
     Carbon filler                       6 parts by weight The thus obtained film connector was used for connection between the electrode of a printed circuit board and the transparent electrode formed on a glass substrate under contact bonding conditions indicated at (7) below, with the results of the resistance on conduction at the connector portion and contact resistance portion in Table 2 following contact bonding conditions (4). In Table 2, there are also shown the results of the electrical resistance of a film connector of the type whose conductive circuit patten is made of a conductive paste alone.

(7) Contact bonding conditions (in air) Temperature   150°C Time          10 seconds Pressure          40 kg/cm$^2$

Table 2

----------------------------------------------------------

|  | Electric Resistance on conduction, 25 mm in length x 0.325 mm in width |
| --- | --- |
| known connector | 6.0 k$\Omega$ ± 0.5 k$\Omega$ |
| copper.nickel laminate type | 0.04 k$\Omega$ ± 0.01 k$\Omega$ |

INDUSTRIAL UTILIZABILITY

As will be appreciated from the foregoing, the conductive circuit pattern of the film connector according to the invention has a metallic thin pattern layer of low resistance as one of the constituent layers, so that good electrical characteristics are ensured. The conductive circuit pattern unit is connected to a counter electrode by the bonding action of a hot-melt adhesive, so that complete bonding is ensured without involving any danger of conduction failure in a long-term service. Thus, reliable connection ic achieved.

According to the method of the invention, the conductive circuit pattern unit is formed by the simple step of forming a metal thin film and a printing step and thus, a film connector having a desired conductive circuit pattern unit can be readily made.

2. WHAT IS CLAIMED IS:

1. A film connector adapted for use in connection between printed circuit boards or between a printed circuit board and an electrode of an electrical and electronic apparatus, characterized by comprising an insulative base film, a conductive circuit pattern unit formed on said base film and consisting of a laminate of a conductive metal thin pattern layer and a printed pattern layer printed with a conductive ink on said conductive metal thin pattern layer, and an anisotropically conductive hot-melt adhesive layer formed on the surface on which the conductive circuit pattern unit has been formed.

2. A film connector adapted for use in connection between printed circuit boards or between a printed circuit board and an electrode of an electrical and electronic apparatus, characterized by comprising an insulative base film, a conductive circuit pattern unit formed on said base film and consisting of a laminate of a conductive metal thin pattern layer, which consists of at least two sub-layers of different metal materials, and a printed pattern layer printed with a conductive ink on said conductive metal thin pattern layer, and an anisotropically conductive hot-melt adhesive layer formed on the surface on which the conductive circuit pattern unit has been formed.

3. A film connector adapted for use in connection between printed circuit boards or between a printed circuit
board and an electrode of an electrical and electronic
apparatus, characterized by comprising an insulative base film,
a conductive circuit pattern unit formed on said base film and
consisting of a laminate of a 500 - 500 angstrom thick
conductive metal thin pattern layer and a printed pattern
layer printed with a conductive ink on said conductive
metallic thin pattern layer, and an anisotropically conductive
hot-melt adhesive layer, which comprises 100 parts by weight
of a hot-melt adhesive and 0.1 - 20 parts by weight of a
conductive powder, formed on the surface on which the
conductive circuit pattern unit has been formed.

4.  A method for making a film connector adapted for use
in connection between printed circuit boards or between a
printed circuit board and an electrode of an electrical and
electronic apparatus, characterized by comprising:

(1) the step of forming a metal thin layer on an
insulative base film by the use of a conductive metal
material;

(2) the step of forming, on said metal thin layer, a
printed pattern layer of a desired form by the use of a
conductive ink having serving as an etching resist;

(3) the step of etching said metal thin layer through
the etching resist of said printed pattern layer to form a
metal thin pattern layer corresponding in shape to the printed pattern layer whereby a conductive circuit pattern unit consisting of a laminate of the printed pattern layer on the metal thin pattern layer is formed; and

(4) the step of forming an anisotropically conductive hot-melt adhesive layer on the surface on which said conductive circuit pattern unit has been formed.

5. A method for making a film connector adapted for use in connection between printed circuit boards or between a printed circuit board and an electrode of an electrical and electronic apparatus, characterized by comprising:

(1) the step of forming a metal thin layer on an insulative base film, said metal thin layer consisting of at least two sub-layers of different metal materials;

(2) the step of forming, on said metal thin layer, a printed pattern layer of a desired form by the use of a conductive ink having serving as an etching resist;

(3) the step of etching said metal thin layer through the etching resist of said printed pattern layer to form a metal thin pattern layer corresponding in shape to the printed pattern layer whereby a conductive circuit pattern unit consisting of a laminate of the printed pattern layer on the metal thin pattern layer is formed; and

(4) the step of forming anisotropically conductive hot-melt adhesive layer on the surface on which said conductive circuit pattern unit has been formed.

FIG. 1

FIG. 2

FIG. 3

FIG. 4-a

FIG. 4-b

FIG. 5

FIG. 6

FIG. 7

FIG. 8

FIG. 9

FIG. 10

F I G. 11

14    15    14    15    14    15    14

─13

F I G. 12

15          15          15

─14

─13

# INTERNATIONAL SEARCH REPORT

International Application No. PCT/JP84/00626

## I. CLASSIFICATION OF SUBJECT MATTER (if several classification symbols apply, indicate all) [3]

According to International Patent Classification (IPC) or to both National Classification and IPC

Int. Cl$^4$ H01R11/01, 43/00, H05K1/11, 3/32, G09F9/00, H01B5/16

## II. FIELDS SEARCHED

| Minimum Documentation Searched [4] | |
|---|---|
| Classification System | Classification Symbols |
| IPC | H01R11/01, 43/00, H05K1/11, 3/32, G09F9/00, H01B5/16 |

| Documentation Searched other than Minimum Documentation to the Extent that such Documents are Included in the Fields Searched [5] | |
|---|---|
| Jitsuyo Shinan Koho | 1922 – 1984 |
| Kokai Jitsuyo Shinan Koho | 1971 – 1984 |

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| X | JP, A, 58-115779 (Shinetsu Polymer Kabushiki Kaisha) 9 July 1983 (09. 07. 83) Figs. 4, 5 (Family nashi) | 1 – 3 |
| Y | JP, B2, 58-56996 (Suwa Seikosha Kabushiki Kaisha) 17 December 1983 (17. 12. 83) & JP, A, 52-70369 | 1 – 3 |
| Y | JP, A, 51-20941 (Suwa Seikosha Kabushiki Kaisha) 19 February 1976 (19. 02. 76) & JP, A, 51-21192 & NL, A, 7509591 & DE, A1, 2536361 & FR, A1, 2282148 & GB, A, 1477780 & US, A, 4113981 & CH, A, 607666 & HK, A, 43281 & FR, B1, 2282148 & NL, B, 172104 & NL, C, 172104 | 1 – 3 |
| A | JP, B2, 58-12586 (Nippon Kokuen Kogyo Kabushiki Kaisha) 9 March 1983 (09. 03. 83) & JP, A, 55-60987 | 1 – 6 |
| A | JP, B2, 58-12587 (Nippon Kokuen Kogyo Kabushiki Kaisha) 9 March 1983 (09. 03. 83) & JP, A, 55-69186 | 1 – 6 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| March 11, 1985   (11. 03. 85) | March 18, 1985   (18. 03. 85) |
| International Searching Authority [1] | Signature of Authorized Officer [20] |
| Japanese Patent Office | |

Form PCT/ISA/210 (second sheet) (October 1981)

0170703

| FURTHER INFORMATION CONTINUED FROM THE SECOND SHEET | | |
|---|---|---|
| A | JP, A, 56-145680 (Nippon Kokuen Kogyo Kabushiki Kaisha) 12 November 1981 (12. 11. 81) (Family nashi) | 1 - 6 |
| A | JP, A, 57-208529 (Toshiba Corp.) 21 December 1982 (21. 12. 82) (Family nashi) | 1 - 3 |
| A | JP, U, 57-9177 (Nippon Kokuen Kogyo Kabushiki Kaisha) 18 January 1982 (18. 01. 82) (Family nashi) | 1 |
| A | JP, A, 58-4277 (Sharp Corp.) 11 January 1983 (11. 01. 83) Fig. 3 (Family nashi) | 1 |

**V.☐ OBSERVATIONS WHERE CERTAIN CLAIMS WERE FOUND UNSEARCHABLE** [10]

This international search report has not been established in respect of certain claims under Article 17(2) (a) for the following reasons:

1.☐ Claim numbers_____ because they relate to subject matter [12] not required to be searched by this Authority, namely:

2.☐ Claim numbers_____ because they relate to parts of the international application that do not comply with the prescribed requirements to such an extent that no meaningful international search can be carried out [13], specifically:

**VI.☐ OBSERVATIONS WHERE UNITY OF INVENTION IS LACKING** [11]

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest
☐ The additional search fees were accompanied by applicant's protest.
☐ No protest accompanied the payment of additional search fees.

Form PCT/ISA/210 (supplemental sheet (2)) (October 1981)